# EUROPEAN PATENT APPLICATION

(11) **EP 4 550 161 A1**
(43) Date of publication of application: **07.05.2025**
(21) Application number: 24209780.6
(22) Date of filing: 30.10.2024
(51) Int. Cl.: G06F 13/42

(54) **SYNCHRONOUS TRANSMISSION METHOD, AND CHIP AND SERIAL COMMUNICATION SYSTEM APPLYING THE SAME**

(30) Priority: 03.11.2023 CN 202311459388
(71) Applicant: Silergy Semiconductor Technology (Hangzhou) Ltd, Zhejiang 310051 (CN)
(72) Inventor: YANG, Yuanyu, Hangzhou City, Zhejiang Province, 310051 (CN); XU, Xiaoqiang, Hangzhou City, Zhejiang Province, 310051 (CN); WANG, Jianxin, Hangzhou City, Zhejiang Province, 310051 (CN)
(74) Representative: Viering, Jentschura & Partner mbB Patent- und Rechtsanwälte

(57) **Abstract**

A synchronous transmission method, and a chip and a serial communication system applying the same are provided. Synchronous control intervals and data control intervals are alternately arranged based on a time sequence, ensuring that during the synchronous control intervals, the periods of the input and output signals are synchronized, and during the data control intervals, the data that the slaves need to output is generated. The start moment of the period of the output signal is controlled by the input signal, while the data of the output signal is controlled by the first signal. Additionally, the synchronous transmission method of the present disclosure uses a lower internal clock frequency within the chip, reducing digital power consumption and chip area, which in turn lowers the chip cost.

## Description

### FIELD OF THE INVENTION

The present disclosure relates to the field of power electronics, and more particularly, to a synchronous transmission method, and a chip and a serial communication system applying the same.

### BACKGROUND OF THE INVENTION

Single-wire serial communication offers several advantages, including fewer communication ports, low power consumption, compact packaging, and simple design. It's widely used in automatic control systems, industrial control, smart homes, and intelligent transportation. In current technologies, when using single-wire serial communication, the internal clock of each slave is typically used for reply and synchronization. The input signal of the slave is asynchronous with its internal clock, usually resulting in a delay of one to two cycles between the output and input signals of the slave. Additionally, the delay can vary between different edges. After multiple stages of cascading, the high or low levels of the transmitted signal and the duty cycle can change to varying degrees, leading to transmission errors.

### SUMMARY OF THE INVENTION

In view of this, the present disclosure provides a synchronous transmission method, and a chip and a serial communication system applying the same.

In a first aspect, the present disclosure provides a synchronous transmission method. The synchronous transmission method is applied to a serial communication system, and the serial communication system comprises slaves and a master coupled in series. The synchronous transmission method comprises: in a synchronous control interval of a control period, controlling an output signal of a corresponding slave according to an input signal of the corresponding slave; and in a data control interval of the control period, controlling the output signal of the corresponding slave according to a first signal, to make a period of the output signal be synchronized with a period of the input signal. A start moment of a first period of the first signal is delayed by a first duration compared to a start moment of a first period of the input signal.

In one embodiment, the first duration is greater than k times the period of the input signal and less than (k +0.5) times the period of the input signal, where k is an integer and not less than zero.

In one embodiment, each of the control periods corresponds to one period of the input signal.

In one embodiment, a start moment of each synchronous control interval is before a start moment of a corresponding period of the input signal, and an end moment of the synchronous control interval is between the start moment of the corresponding period of the input signal and a middle point of the corresponding period of the input signal.

In one embodiment, a start moment of each data control interval is between a start moment of a corresponding period of the input signal and a middle point of the corresponding period of the input signal, and an end moment of the data control interval is between the middle point of the corresponding period of the input signal and an end moment of the corresponding period of the input signal.

In one embodiment, synchronous control intervals and data control intervals of the control periods are alternately arranged based on a time sequence.

In one embodiment, a level relationship between the output signal and the input signal in the synchronous control interval is controlled according to levels of the input signal and one of the first signal and the output signal before a start moment of the synchronous control interval, or according to pulse edge jump manners of the input signal and one of the first signal and the output signal in the synchronous control interval.

In one embodiment, before the start moment of the synchronous control interval, the level of the input signal and the level of the first signal are sampled; when the level of the input signal is the same as the level of the first signal, the level of the output signal is the same as the level of the input signal in the synchronous control interval; and when the level of the input signal is opposite to the level of the first signal, the level of the output signal is opposite to the level of the input signal in the synchronous control interval.

In one embodiment, before the start moment of the synchronous control interval, the level of the input signal and the level of the output signal are sampled; when the level of the input signal is the same as the level of the output signal, the level of the output signal is the same as the level of the input signal in the synchronous control interval; and when the level of the input signal is opposite to the level of the output signal, the level of the output signal is opposite to the level of the input signal in the synchronous control interval.

In one embodiment, in the synchronous control interval, when the pulse edge jump manner of the input signal is the same as the pulse edge jump manner of one of the first signal and the output signal, the level of the output signal is the same as the level of the input signal in the synchronous control interval; and when the pulse edge jump manner of the input signal is opposite to the pulse edge jump manner of one of the first signal and the output signal, the level of the output signal is opposite to the level of the input signal in the synchronous control interval.

In one embodiment, a level of the output signal is the same as a level of the first signal in each data control interval.

In a second aspect, the present disclosure provides a chip, comprising an input terminal, an output terminal, and a communication processing module. The input terminal is configured to receive an input signal. The output terminal is configured to output an output signal. The communication processing module is coupled between the input terminal and the output terminal and is configured to generate the output signal. In a synchronous control interval of a control period, the output signal is controlled by the input signal, and in a data control interval of the control period, the output signal is controlled by a first signal, such that a period of the output signal is synchronized with a period of the input signal. A start moment of a first period of the first signal is delayed by a first duration compared to a start moment of a first period of the input signal.

In one embodiment, the first duration is greater than k times the period of the input signal and less than (k +0.5) times the period of the input signal, where k is an integer and not less than zero.

In one embodiment, each of the control periods corresponds to one period of the input signal.

In one embodiment, a start moment of each synchronous control interval is before a start moment of a corresponding period of the input signal, and an end moment of the synchronous control interval is between the start moment of the corresponding period of the input signal and a middle point of the corresponding period of the input signal.

In one embodiment, a start moment of each data control interval is between a start moment of a corresponding period of the input signal and a middle point of the corresponding period of the input signal, and an end moment of the data control interval is between the middle point of the corresponding period of the input signal and an end moment of the corresponding period of the input signal.

In one embodiment, the communication processing module is configured to control a level relationship between the output signal and the input signal in the synchronous control interval according to levels of the input signal and one of the first signal and the output signal before a start moment of the synchronous control interval, or according to pulse edge jump manners of the input signal and one of the first signal and the output signal in the synchronous control interval.

In one embodiment, before the start moment of the synchronous control interval, the level of the input signal and the level of the first signal are sampled; when the level of the input signal is the same as the level of the first signal, the level of the output signal is the same as the level of the input signal in the synchronous control interval; and when the level of the input signal is opposite to the level of the first signal, the level of the output signal is opposite to the level of the input signal in the synchronous control interval.

In one embodiment, before the start moment of the synchronous control interval, the level of the input signal and the level of the output signal are sampled; when the level of the input signal is the same as the level of the output signal, the level of the output signal is the same as the level of the input signal in the synchronous control interval; and when the level of the input signal is opposite to the level of the output signal, the level of the output signal is opposite to the level of the input signal in the synchronous control interval.

In one embodiment, in the synchronous control interval, when the pulse edge jump manner of the input signal is the same as the pulse edge jump manner of one of the first signal and the output signal, the level of the output signal is the same as the level of the input signal in the synchronous control interval; and when the pulse edge jump manner of the input signal is opposite to the pulse edge jump manner of one of the first signal and the output signal, the level of the output signal is opposite to the level of the input signal in the synchronous control interval.

In one embodiment, a level of the output signal is the same as a level of the first signal in each data control interval.

In one embodiment, the communication processing module comprises a synchronous transmission circuit, and the synchronous transmission circuit comprises a first switch, a second switch, and a third switch. The output terminal of the chip receives the first signal through the first switch, and the input terminal of the chip is coupled to the output terminal of the chip through the second switch, and/or through the third switch and an inverter.

In one embodiment, the first switch is turned off in each synchronous control interval and is turned on in each data control interval.

In one embodiment, the second switch and the third switch are selectively turned on in each synchronous control interval, and both are turned off in each data control interval.

In one embodiment, before a start moment of each synchronous control interval, levels of the input signal and one of the first signal and the output signal are sampled; when the level of the input signal is the same as the level of one of the first signal and the output signal, the second switch is turned on and the third switch is turned off in the synchronous control interval; and when the level of the input signal is opposite to the level of one of the first signal and the output signal, the third switch is turned on and the second switch is turned off in the synchronous control interval.

In one embodiment, in the synchronous control interval, when a pulse edge jump manner of the input signal is the same as a pulse edge jump manner of one of the first signal and the output signal, the second switch is turned on and the third switch is turned off in the synchronous control interval; and when the pulse edge jump manner of the input signal is opposite to the pulse edge jump manner of one of the first signal and the output signal, the third switch is turned on and the second switch is turned off in the synchronous control interval.

In one embodiment, the communication processing module comprises a synchronous transmission circuit, and the synchronous transmission circuit comprises a multiplexer. A first input terminal of the multiplexer receives the first signal, a second input terminal of the multiplexer is coupled to the input terminal of the chip, a third input terminal of the multiplexer is coupled to the input terminal of the chip through an inverter, an output terminal of the multiplexer is coupled to the output terminal of the chip, a first control terminal of the multiplexer receives a first control signal, and a second control terminal of the multiplexer receives a second control signal.

In one embodiment, the multiplexer selectively transmits the first signal, the input signal, and an inverted signal of the input signal to the output terminal of the chip according to the first control signal and the second control signal.

In a third aspect, the present disclosure provides a serial communication system, comprising slaves and a master coupled in series. Each of the slaves is configured as a chip described in the second aspect of the present disclosure. The slaves and the master are coupled through a single-line bus.

Compared with the existing technology, the present disclosure has the following advantages. The synchronous transmission method is applied to a serial communication system, and the serial communication system comprises slaves and a master coupled in series. The synchronous transmission method comprises: in a synchronous control interval of a control period, controlling an output signal of a corresponding slave according to an input signal of the corresponding slave; and in a data control interval of the control period, controlling the output signal of the corresponding slave according to a first signal, to make a period of the output signal be synchronized with a period of the input signal. A start moment of a first period of the first signal is delayed by a first duration compared to a start moment of a first period of the input signal. In the present disclosure, synchronous control intervals and data control intervals of the control periods are alternately arranged based on a time sequence, ensuring that during the synchronous control intervals, the periods of the input and output signals are synchronized, and during the data control intervals, the data that the slaves need to output is generated. The start moment of the period of the output signal is controlled by the input signal, while the data of the output signal (whether it's zero or one) is controlled by the first signal. Additionally, the synchronous transmission method of the present disclosure uses a lower internal clock frequency within the chip, reducing digital power consumption and chip area, which in turn lowers the chip cost.

### BRIEF DESCRIPTION OF DRAWINGS

The above and other objects, features and advantages of the present disclosure will become more apparent from the following description of embodiments of the disclosure with reference to the accompanying drawings, in which:
FIG. 1 is a schematic diagram of a serial communication system according to an embodiment of the present disclosure.
FIG. 2 is a schematic diagram illustrating waveforms of two different signals in the present disclosure.
FIG. 3 is a schematic waveform diagram of a synchronous transmission method according to the present disclosure.
FIG. 4 is a schematic diagram of a synchronous transmission circuit according to Embodiment 1 of the present disclosure.
FIG. 5 is a working waveform diagram of the synchronous transmission circuit according to Embodiment 1 of the present disclosure.
FIG. 6 is a schematic diagram of a synchronous transmission circuit according to Embodiment 2 of the present disclosure.

### DETAILED DESCRIPTION OF THE INVENTION

The following description of the present disclosure is based on exemplary embodiments; however, the present disclosure is not restricted to these embodiments. In the detailed description below, specific details are provided to facilitate a thorough understanding of the present disclosure. It will be apparent to those skilled in the art that the present disclosure can be practiced without these specific details. To avoid obscuring the essence of the present disclosure, well-known methods, processes, procedures, components, and circuits are not described in detail.

Moreover, it should be understood by those skilled in the art that the accompanying drawings are provided for illustrative purposes and are not necessarily drawn to scale.

It should be understood that in the following description, a "circuit" refers to a conductive loop formed by at least one component or sub-circuit through electrical or electromagnetic connections. When a component or circuit is described as "connected to" another component or as "connected between" two nodes, it can be directly coupled or connected to the other component, or there may be intermediate components. The connections between components can be physical, logical, or a combination of both. Conversely, when a component is described as "directly coupled to" or "directly connected to" another component, it means that there are no intermediate components between them.

The terms "comprising", "including", and similar terms throughout the present disclosure should be interpreted as inclusive rather than exclusive or exhaustive; that is, meaning "including, but not limited to."

It should be understood that the terms such as "first" and "second" are used for indication purpose only and should not be construed as indicating or implying relative importance. In the present disclosure, "a plurality of" means two or more, unless otherwise expressly specified.

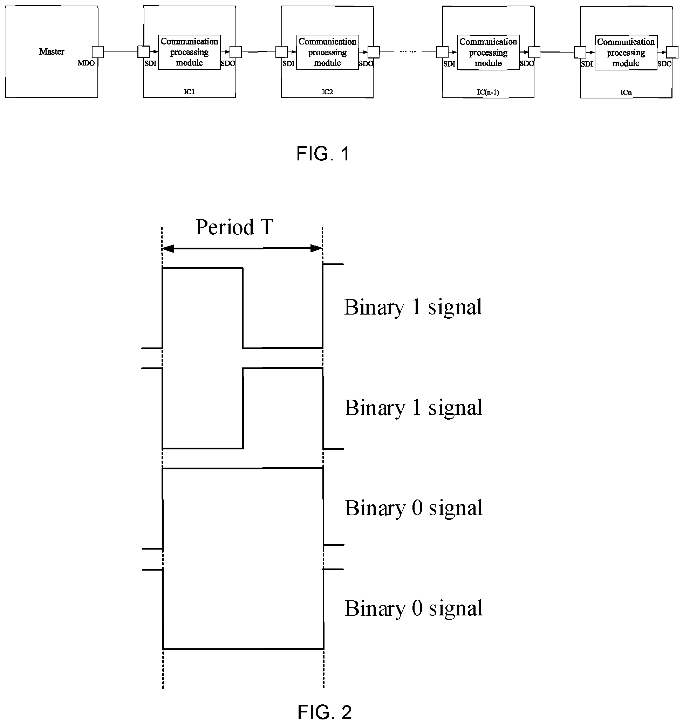

FIG. 1 is a schematic diagram of a serial communication system according to an embodiment of the present disclosure. The serial communication system comprises N slaves (i.e., chips) IC1-ICN and a master coupled in series in turn, where N is greater than or equal to 1. Each slave comprises an input terminal SDI and an output terminal SDO, and an input terminal SDI of the first slave IC1 among the slaves is connected to an output terminal MDO of the master. An input terminal SDI of each of the slaves IC2-ICN is connected to an output terminal SDO of a previous slave, respectively. The input terminal SDI of each slave is configured to receive an input signal, and the output terminal SDO of each slave is configured to output an output signal.

Each slave further comprises a communication processing module, and the communication processing module is coupled between the input terminal SDI and the output terminal SDO of the slave and is configured to generate the output signal. In a synchronous control interval of each of control periods, the output signal is controlled by the input signal, and in a data control interval of each of the control periods, the output signal is controlled by a first signal, such that a period of the output signal is synchronized with a period of the input signal. A start moment of a first period of the first signal is delayed by a first duration compared to a start moment of a first period of the input signal. The first duration is greater than k times the period of the input signal and less than (k +0.5) times the period of the input signal, where k is an integer not less than zero. Preferably, k=1, that is, the first duration is greater than the period of the input signal and less than 1.5 times the period of the input signal. Embodiments of the present disclosure are described taking the first duration being greater than the period of the input signal and less than 1.5 times the period of the input signal as an example, but the embodiments of the present disclosure are not limited thereto, and in other embodiments, k may be 0, 2, 3,...,and so on.

Further, each communication processing module comprises a data processing module (not shown in FIG. 1) that generates the first signal. The first signal represents data that the slaves are intended to output, that is, the first signal determines whether the data of the output signal is 0 or 1. The data of the input signal and the output signal (or the first signal) may be either related or unrelated. For example, in one embodiment, the communication processing module is configured to forward or process and then forward communication data packets or commands from the input signal received by a corresponding slave. The processing of the communication data packets comprises modifying relevant data in the communication data packets to generate the output signal. In another embodiment, the communication processing modules are configured to output signals with consistent data, irrespective of the input signal's data. In one embodiment, the master and the slaves (IC1 ~ICN) are connected in series through a single-line bus. In one embodiment, the output terminal SDO of the Nth slave ICN is not connected to an input terminal of the master, as long as one-way data transmission is achieved, without forming a circular serial communication. In another embodiment, the output terminal SDO of the Nth slave ICN is connected to the input terminal of the master to form the circular serial communication.

FIG. 2 is a schematic diagram illustrating waveforms of two different signals in the present disclosure, defined as a binary 0 signal and a binary 1 signal. As shown in FIG. 2, the binary 0 signal maintains either a high level or a low level in one period T (i.e., one data frame) without any pulse edge jump (i.e., no level inversion). In contrast, the binary 1 signal comprises both high and low levels within one period T (i.e., one data frame) and exhibits pulse edge jump (i.e., there is level inversion), which can occur from high level to low level or low level to high level. The invention does not limit the duty cycle of the binary 1 signal. In one embodiment, the pulse edge jump occurs at both the start moment and the end moment of each period of each signal.

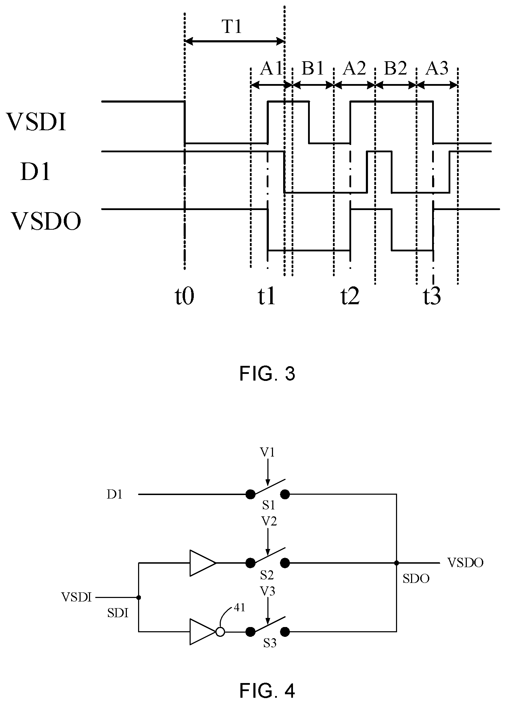

The working principle of the communication processing module is illustrated in FIG. 3, which shows a schematic waveform diagram of the synchronous transmission method of the present disclosure. In FIG. 3, VSDI represents the input signal, D1 represents the first signal, VSDO represents the output signal, Ai represents the synchronous control interval in an i-th control period, Bi represents the data control interval in the i-th control period, and T1 represents the first duration.

As shown in FIG. 3, each control period corresponds to one period of the input signal VSDI. In one embodiment, the first control period corresponds to the second period (t1-t2 interval) of the input signal VSDI, the second control period corresponds to the third period (t2-t3 interval) of the input signal VSDI, and so on, the i-th control period corresponds to the (i+1)th period of the input signal VSDI. In other embodiments, the i-th control period corresponds to the i-th period of the input signal VSDI. A start moment of the first period of the first signal is delayed by the first duration T1 compared to a start moment of the first period of the input signal.

A start moment of the synchronous control interval A1 in the first control period is before a start moment t1 of the second period of the input signal VSDI, and an end moment of the synchronous control interval A1 is between the start moment t1 of the second period of the input signal VSDI and a middle point of the second period of the input signal VSDI; A start moment of the synchronous control interval A2 in the second control period is before a start moment t2 of the third period of the input signal VSDI, and an end moment of the synchronous control interval A2 is between the start moment t2 of the third period of the input signal VSDI and a middle point of the third period of the input signal VSDI. It can be seen therefrom that a start moment of one synchronous control interval is before a start moment of a corresponding period of the input signal, and an end moment of the synchronous control interval is between the start moment of the corresponding period of the input signal and a middle point of the corresponding period of the input signal.

A start moment of the data control interval B1 in the first control period is between a start moment t1 of the second period of the input signal VSDI and a middle point of the second period of the input signal VSDI, and an end moment of the data control interval B1 is between the middle point of the second period of the input signal VSDI and an end moment t2 of the second period of the input signal VSDI; a start moment of the data control interval B2 in the second control period is between a start moment t2 of the third period of the input signal VSDI and a middle point of the third period of the input signal VSDI, and an end moment of the data control interval B2 is between the middle point of the third period of the input signal VSDI and an end moment t3 of the third period of the input signal VSDI. In essence, in one embodiment, the end moment of the second period of the input signal VSDI and the start moment of the third period of the input signal VSDI are the same. It can be seen therefrom that a start moment of one data control interval is between a start moment of a corresponding period of the input signal and a middle point of the corresponding period of the input signal, and an end moment of the data control interval is between the middle point of the corresponding period of the input signal and an end moment of the corresponding period of the input signal.

Further, each communication processing module is configured to control a level relationship between the output signal and the input signal in the synchronous control interval based on levels of the input signal and at least one of the first signal and the output signal before a start moment of the synchronous control interval, or based on pulse edge jump manners of the input signal and at least one of the first signal and the output signal in the synchronous control interval. Specifically, each communication processing module is configured to generate the output signal in the following four manners.

In a first manner, before the start moment of the synchronous control interval, the level of the input signal and the level of the first signal are sampled; when the level of the input signal is the same as the level of the first signal, the level of the output signal is the same as the level of the input signal in the synchronous control interval; and when the level of the input signal is opposite to the level of the first signal, the level of the output signal is opposite to the level of the input signal in the synchronous control interval.

In a second manner, before the start moment of the synchronous control interval, the level of the input signal and the level of the output signal are sampled; when the level of the input signal is the same as the level of the output signal, the level of the output signal is the same as the level of the input signal in the synchronous control interval; and when the level of the input signal is opposite to the level of the output signal, the level of the output signal is opposite to the level of the input signal in the synchronous control interval.

In a third manner, in the synchronous control interval, when the pulse edge jump manner of the input signal is the same as the pulse edge jump manner of the first signal (which can occur from high level to low level or low level to high level), the level of the output signal is the same as the level of the input signal in the synchronous control interval; and when the pulse edge jump manner of the input signal is opposite to the pulse edge jump manner of the first signal, the level of the output signal is opposite to the level of the input signal in the synchronous control interval.

In a fourth manner, in the synchronous control interval, when the pulse edge jump manner of the input signal is the same as the pulse edge jump manner of the output signal, the level of the output signal is the same as the level of the input signal in the synchronous control interval; and when the pulse edge jump manner of the input signal is opposite to the pulse edge jump manner of the output signal, the level of the output signal is opposite to the level of the input signal in the synchronous control interval.

The level of the output signal is the same as the level of the first signal in each data control interval.

In one embodiment, both the input signal and the output signal are configured to be at a high level when it is not operating. In other embodiments, the input signal and the output signal may be at a low level when it is not operating. In one embodiment, the end moment of a synchronous control interval and the start moment of a corresponding data control interval following said synchronous control interval are the same. In other embodiments, the synchronous control interval and the corresponding data control interval following said synchronous control interval are separated by a certain period of time. In one embodiment, the first duration T1 is greater than the period of the input signal but less than 1.5 times the period of the input signal. However, any embodiment where the first duration T1 is greater than k times the period of the input signal and is less than (k+0.5) times the period of the input signal, where k is a non-negative integer, falls within the scope of the present disclosure.

The first manner is combined with FIG. 3 to illustrate the working principle of the communication processing module. The first period of the input signal VSDI spans from t0 to t1. It needs to enter the synchronous control interval A1 before the start moment t1 of the second period of the input signal VSDI (or, before the end moment t1 of the first period of the input signal VSDI). Before the start moment of the synchronous control interval A1, the input signal VSDI is at a low level, while the first signal D1 is at a high level, meaning the levels of the input signal VSDI and the first signal D1 are opposite, such that the level of the output signal VSDO is opposite to the level of the input signal VSDI in the synchronous control interval A1; then, it enters the data control interval B1, where the level of the output signal VSDO is the same as the level of the first signal D1. Before the start moment of the synchronous control interval A2, both the input signal VSDI and the first signal D1 are at a low level, meaning the levels of the input signal VSDI and the first signal D1 are same, such that the level of the output signal VSDO is the same as the level of the input signal VSDI in the synchronous control interval A2; then, it enters the data control interval B2, where the level of the output signal VSDO is the same as the level of the first signal D1. And so on, synchronous control intervals and data control intervals of the control periods are alternately arranged based on a time sequence, ensuring that during the synchronous control intervals, the periods of the input and output signals are synchronized, and during the data control intervals, the data that the slaves need to output is generated, thereby generating the output signals.

The serial communication system of the present disclosure comprises multiple chips connected in series and utilizes single-wire communication to transmit large amounts of data. By employing synchronous or near-synchronous methods, the serial communication system achieves reduced data transmission time. The present disclosure addresses the issue of periodic synchronization in communication system including multiple chips connected in series during single-wire communication. The communication processing module generates the output signal based on the input signal during the synchronous control intervals and based on the first signal during the data control intervals. Essentially, the start moment of each period of the output signal (i.e., the pulse edge indicating the beginning of the period) is controlled by the input signal, while whether the data of the output signal is 0 or 1 (i.e., whether a level edge jump occurs within a period) is controlled by the first signal. Synchronous control and data control alternate in sequence, ensuring that the period of the output signal aligns with the period of the input signal (i.e., achieving synchronization). The data of a period of the output signal is the same as the data of the corresponding period of the first signal, making the output signal a periodically corrected version of the first signal. Moreover, the synchronous transmission method of the present disclosure can achieve synchronization using a lower clock frequency inside the chip, reducing digital power consumption and chip area, and ultimately lowering chip costs.

Further, the communication processing module further comprises a synchronous transmission circuit, and the synchronous transmission circuit is configured to generate the output signal based on the first signal and the input signal. FIG. 4 is a schematic diagram of a synchronous transmission circuit according to Embodiment 1 of the present disclosure. As shown in FIG. 4, the synchronous transmission circuit comprises a first switch S1, a second switch S2, and a third switch S3. The output terminal SDO of the chip receives the first signal D1 through the first switch S1, and the input terminal SDI of the chip is coupled to the output terminal SDO of the chip through the second switch S2 and/or through the third switch S3 and an inverter 41. Specifically, the third switch S3 and the inverter 41 are coupled in series between the input terminal SDI and the output terminal SDO. Optionally, the synchronous transmission circuit further comprises a first buffer, and the first buffer is configured to be coupled in series with the second switch S2 between the input terminal SDI and the output terminal SDO to enhance driving. Optionally, in one embodiment, the synchronous transmission circuit comprises a second buffer, and the second buffer is configured to be coupled in series with the third switch S3 and the inverter 41 between the input terminal SDI and the output terminal SDO to enhance driving. In another embodiment, the inverter 41 is configured as an inverting buffer to enhance driving.

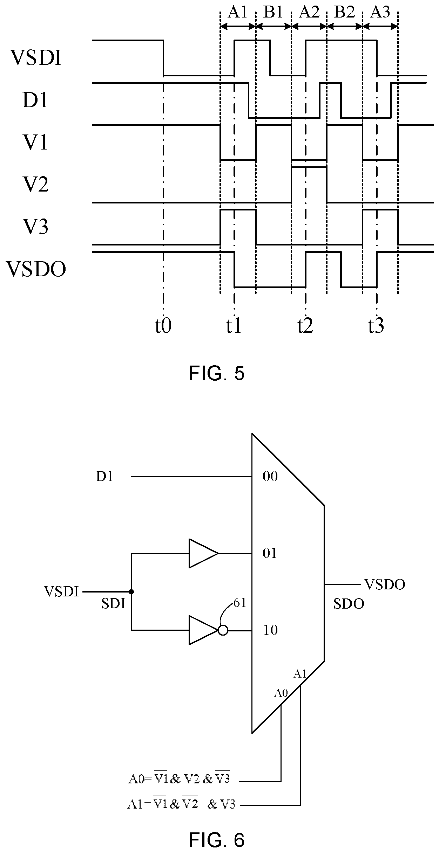

FIG. 5 is a working waveform diagram of the synchronous transmission circuit according to Embodiment 1 of the present disclosure. In FIG. 5, VSDI represents the input signal, D1 represents the first signal, VSDO represents the output signal, Ai represents the synchronous control interval in an i-th control period, Bi represents the data control interval in the i-th control period, V1 represents a control signal of the first switch S1, V2 represents a control signal of the second switch S2, and V3 represents a control signal of the third switch S3.

The working process of the synchronous transmission circuit is described with reference to FIGs. 4 and 5. As shown in FIG. 5, in the synchronous control intervals (i.e., intervals A1, A2 and A3), the control signal V1 is at a low level, and the first switch S1 is turned off; and in the data control intervals (i.e., intervals B1 and B2), the control signal V1 is at a high level, and the first switch S1 is turned on, during which time, the levels of the output signal SDO and the input signal SDI are the same.

In the data control intervals (i.e., intervals B1 and B2), the control signals V2 and V3 are both at a low level, and the second switch S2 and the third switch S3 are turned off; and one of the control signals V2 and V3 is at a high level during the synchronous control intervals (i.e., A1, A2 and A3 intervals), causing the switch corresponding to the high-level control signal to be turned on.

Optionally, before a start moment of each synchronous control interval (i.e., A1, A2 or A3 interval), levels of the input signal VSDI and one of the first signal D1 and the output signal VSDO are sampled; when the level of the input signal VSDI is the same as the level of one of the first signal D1 and the output signal VSDO, the second switch S2 is turned on and the third switch S3 is turned off in the synchronous control interval; and when the level of the input signal VSDI is opposite to the level of one of the first signal D1 and the output signal VSDO, the third switch S3 is turned on and the second switch S2 is turned off in the synchronous control interval.

Optionally, in each synchronous control interval (i.e., A1, A2 or A3 interval), when a pulse edge jump manner of the input signal VSDI is the same as a pulse edge jump manner of one of the first signal D1 and the output signal VSDO, the second switch S2 is turned on and the third switch S3 is turned off in the synchronous control interval; and when the pulse edge jump manner of the input signal VSDI is opposite to the pulse edge jump manner of one of the first signal D1 and the output signal VSDO, the third switch S3 is turned on and the second switch S2 is turned off in the synchronous control interval.

FIG. 6 is a schematic diagram of a synchronous transmission circuit according to Embodiment 2 of the present disclosure. The communication processing module comprises the synchronous transmission circuit, and the synchronous transmission circuit comprises a multiplexer. The multiplexer comprises a first control terminal, a second control terminal, an output terminal, a first input terminal 00, a second input terminal 01, and a third input terminal 10. Specifically, the first input terminal 00 of the multiplexer receives the first signal D1, the second input terminal 01 of the multiplexer is coupled to the input terminal SDI of the chip to receive input signal VSDI, the third input terminal 10 of the multiplexer is coupled to the input terminal SDI of the chip through an inverter 61 to receive the input signal VSDI, the output terminal of the multiplexer is coupled to the output terminal SDO of the chip to generate the output signal VSDO, the first control terminal of the multiplexer receives a first control signal A1, and the second control terminal of the multiplexer receives a second control signal A0. Optionally, a buffer is coupled between the input terminal SDI and the second input terminal 01 to enhance driving. Optionally, a buffer is coupled between the input terminal SDI and the third input terminal 10 to enhance driving. Optionally, the inverter 61 is configured as an inverting buffer to enhance driving.

Further, the multiplexer selectively transmits the first signal, the input signal, and an inverted signal of the input signal to the output terminal SDO of the chip based on the first control signal A1 and the second control signal A0. Specifically, the first control signal A1 is configured to be a signal obtained by ANDing an inverted signal of the control signal V1, an inverted signal of the control signal V2, and the control signal V3 in FIG. 5, that is, A1=V̅1̅ & V̅2̅ & V3; the second control signal A0 is configured to be a signal obtained by ANDing the inverted signal of the control signal V1, the control signal V2, and an inverted signal of the control signal V3 in FIG. 5, that is, A0= V̅1̅ & V2 & V̅3̅. When A1A0 is 00, the multiplexer outputs the first signal D1 as the output signal. When A1A0 is 01, the multiplexer outputs the input signal VSDI as the output signal. When A1A0 is 10, the multiplexer outputs the inverted signal of the input signal VSDI as the output signal.

The present disclosure further provides a synchronous transmission method. The synchronous transmission method is applied to a serial communication system, and the serial communication system comprises slaves and a master coupled in series. The synchronous transmission method comprises: in a synchronous control interval of a control period, controlling an output signal of a corresponding slave according to an input signal of the corresponding slave; in a data control interval of the control period, controlling the output signal of the corresponding slave according to a first signal, to make a period of the output signal be synchronized with a period of the input signal. A start moment of a first period of the first signal is delayed by a first duration compared to a start moment of a first period of the input signal.

The first duration is greater than k times the period of the input signal and less than (k+0.5) times the period of the input signal, where k is an integer and not less than zero. Preferably, the first duration is greater than the period of the input signal and less than 1.5 times the period of the input signal.

Further, each control period corresponds to one period of the input signal. A start moment of each synchronous control interval is before a start moment of a corresponding period of the input signal, and an end moment of the synchronous control interval is between the start moment of the corresponding period of the input signal and a middle point of the corresponding period of the input signal. A start moment of each data control interval is between a start moment of a corresponding period of the input signal and a middle point of the corresponding period of the input signal, and an end moment of the data control interval is between the middle point of the corresponding period of the input signal and an end moment of the corresponding period of the input signal.

The synchronous control intervals and the data control intervals are alternately arranged based on a time sequence. In one embodiment, the start moment of each data control interval and the end moment of a corresponding synchronous control interval before said data control interval are the same. In other embodiments, said synchronous control interval and the data control interval are separated by a certain period of time.

A level relationship between the output signal and the input signal in the synchronous control interval is controlled according to levels of the input signal and one of the first signal and the output signal before a start moment of the synchronous control interval, or according to pulse edge jump manners of the input signal and one of the first signal and the output signal in the synchronous control interval.

Optionally, before the start moment of the synchronous control interval, the level of the input signal and the level of the first signal are sampled; when the level of the input signal is the same as the level of the first signal, the level of the output signal is the same as the level of the input signal in the synchronous control interval; and when the level of the input signal is opposite to the level of the first signal, the level of the output signal is opposite to the level of the input signal in the synchronous control interval.

Optionally, before the start moment of the synchronous control interval, the level of the input signal and the level of the output signal are sampled; when the level of the input signal is the same as the level of the output signal, the level of the output signal is the same as the level of the input signal in the synchronous control interval; and when the level of the input signal is opposite to the level of the output signal, the level of the output signal is opposite to the level of the input signal in the synchronous control interval.

Optionally, in the synchronous control interval, when the pulse edge jump manner of the input signal is the same as the pulse edge jump manner of the first signal, the level of the output signal is the same as the level of the input signal in the synchronous control interval; and when the pulse edge jump manner of the input signal is opposite to the pulse edge jump manner of the first signal, the level of the output signal is opposite to the level of the input signal in the synchronous control interval.

Optionally, in the synchronous control interval, when the pulse edge jump manner of the input signal is the same as the pulse edge jump manner of the output signal, the level of the output signal is the same as the level of the input signal in the synchronous control interval; and when the pulse edge jump manner of the input signal is opposite to the pulse edge jump manner of the output signal, the level of the output signal is opposite to the level of the input signal in the synchronous control interval.

Further, the level of the output signal is the same as the level of the first signal in each data control interval.

Although the above embodiments are described and explained separately, the common technologies involved can be interchanged and integrated by those skilled in the art. If any details are not explicitly described in one embodiment, they can be referenced from another embodiment where they are documented.

The embodiments are not exhaustive of all the details of the present disclosure, nor do they restrict the present disclosure to only the specific embodiments described. Obviously, various modifications and changes may be made according to the content of this specification. The embodiments are chosen and described in detail in order to better explain the principles of the present disclosure and its practical applications, and to thereby enable the skilled in the art to understand and utilize the present disclosure. The present disclosure is only restricted by the claims and the full scope and equivalents thereof.

## Claims

1. A synchronous transmission method, applied to a serial communication system, wherein the serial communication system comprises slaves and a master coupled in series, and the synchronous transmission method comprises:
in a synchronous control interval of a control period, controlling an output signal of a corresponding slave according to an input signal of the corresponding slave, and
in a data control interval of the control period, controlling the output signal of the corresponding slave according to a first signal, to make a period of the output signal be synchronized with a period of the input signal,
wherein a start moment of a first period of the first signal is delayed by a first duration compared to a start moment of a first period of the input signal.

2. The synchronous transmission method according to claim 1, wherein the first duration is greater than k times the period of the input signal and less than (k +0.5) times the period of the input signal, where k is an integer and not less than zero.

3. The synchronous transmission method according to claim 1, wherein each of the control periods corresponds to one period of the input signal.

4. The synchronous transmission method according to claim 3, wherein a start moment of each synchronous control interval is before a start moment of a corresponding period of the input signal, and an end moment of the synchronous control interval is between the start moment of the corresponding period of the input signal and a middle point of the corresponding period of the input signal.

5. The synchronous transmission method according to claim 3, wherein a start moment of each data control interval is between a start moment of a corresponding period of the input signal and a middle point of the corresponding period of the input signal, and an end moment of the data control interval is between the middle point of the corresponding period of the input signal and an end moment of the corresponding period of the input signal.

6. The synchronous transmission method according to claim 1, wherein synchronous control intervals and data control intervals of the control periods are alternately arranged based on a time sequence.

7. The synchronous transmission method according to claim 1, wherein a level relationship between the output signal and the input signal in the synchronous control interval is controlled according to levels of the input signal and one of the first signal and the output signal before a start moment of the synchronous control interval, or according to pulse edge jump manners of the input signal and one of the first signal and the output signal in the synchronous control interval.

8. The synchronous transmission method according to claim 7, wherein
before the start moment of the synchronous control interval, the level of the input signal and the level of one of the first signal and the output signal are sampled, when the level of the input signal is the same as the level of one of the first signal and the output signal, the level of the output signal is the same as the level of the input signal in the synchronous control interval, and when the level of the input signal is opposite to the level of one of the first signal and the output signal, the level of the output signal is opposite to the level of the input signal in the synchronous control interval; or,
in the synchronous control interval, when the pulse edge jump manner of the input signal is the same as the pulse edge jump manner of one of the first signal and the output signal, the level of the output signal is the same as the level of the input signal in the synchronous control interval; and when the pulse edge jump manner of the input signal is opposite to the pulse edge jump manner of one of the first signal and the output signal, the level of the output signal is opposite to the level of the input signal in the synchronous control interval.

9. The synchronous transmission method according to claim 1, wherein a level of the output signal is the same as a level of the first signal in each data control interval.

10. A chip, comprising:
an input terminal, configured to receive an input signal;
an output terminal, configured to output an output signal; and
a communication processing module, coupled between the input terminal and the output terminal and configured to generate the output signal;
wherein in a synchronous control interval of a control period, the output signal is controlled by the input signal, and in a data control interval of the control period, the output signal is controlled by a first signal, such that a period of the output signal is synchronized with a period of the input signal; wherein a start moment of a first period of the first signal is delayed by a first duration compared to a start moment of a first period of the input signal.

11. The chip according to claim 10, wherein the first duration is greater than k times the period of the input signal and less than (k +0.5) times the period of the input signal, where k is an integer and not less than zero.

12. The chip according to claim 10, wherein a start moment of each synchronous control interval is before a start moment of a corresponding period of the input signal, and an end moment of the synchronous control interval is between the start moment of the corresponding period of the input signal and a middle point of the corresponding period of the input signal.

13. The chip according to claim 10, wherein a start moment of each data control interval is between a start moment of a corresponding period of the input signal and a middle point of the corresponding period of the input signal, and an end moment of the data control interval is between the middle point of the corresponding period of the input signal and an end moment of the corresponding period of the input signal.

14. The chip according to claim 10, wherein a level relationship between the output signal and the input signal in the synchronous control interval is controlled according to levels of the input signal and one of the first signal and the output signal before a start moment of the synchronous control interval, or according to pulse edge jump manners of the input signal and one of the first signal and the output signal in the synchronous control interval.

15. The chip according to claim 14, wherein
before the start moment of the synchronous control interval, the level of the input signal and the level of one of the first signal and the output signal are sampled, wherein when the level of the input signal is the same as the level of one of the first signal and the output signal, the level of the output signal is the same as the level of the input signal in the synchronous control interval, and when the level of the input signal is opposite to the level of one of the first signal and the output signal, the level of the output signal is opposite to the level of the input signal in the synchronous control interval; or,
in the synchronous control interval, when the pulse edge jump manner of the input signal is the same as the pulse edge jump manner of one of the first signal and the output signal, the level of the output signal is the same as the level of the input signal in the synchronous control interval; and when the pulse edge jump manner of the input signal is opposite to the pulse edge jump manner of one of the first signal and the output signal, the level of the output signal is opposite to the level of the input signal in the synchronous control interval.

16. The chip according to claim 10, wherein a level of the output signal is the same as a level of the first signal in each data control interval.

17. The chip according to claim 10, wherein the communication processing module comprises a synchronous transmission circuit, and the synchronous transmission circuit comprises a first switch, a second switch, and a third switch; wherein the output terminal of the chip receives the first signal through the first switch, and the input terminal of the chip is coupled to the output terminal of the chip through the second switch, and/or through the third switch and an inverter.

18. The chip according to claim 17, wherein the first switch is turned off in each synchronous control interval and is turned on in each data control interval;
or,
wherein the second switch and the third switch are selectively turned on in each synchronous control interval, and both are turned off in each data control interval.

19. The chip according to claim 10, wherein the communication processing module comprises a synchronous transmission circuit, and the synchronous transmission circuit comprises a multiplexer; wherein a first input terminal of the multiplexer receives the first signal, a second input terminal of the multiplexer is coupled to the input terminal of the chip, a third input terminal of the multiplexer is coupled to the input terminal of the chip through an inverter, an output terminal of the multiplexer is coupled to the output terminal of the chip, a first control terminal of the multiplexer receives a first control signal, and a second control terminal of the multiplexer receives a second control signal.

20. A serial communication system, comprising slaves and a master coupled in series, wherein each of the slaves is configured as a chip according to any one of claims 10-19;
wherein the slaves and the master are coupled through a single-line bus.
